# EUROPEAN PATENT APPLICATION

(11) **EP 4 488 759 A1**
(43) Date of publication of application: **08.01.2025**
(21) Application number: 23183512.5
(22) Date of filing: 05.07.2023
(51) Int. Cl.: G03F 7/20, H01L 21/687

(54) **OBJECT HOLDER WITH A REVERSIBLY CHANGEABLE CRYSTALLINE/AMORPHOUS PHASE MATERIAL CONFIGURED TO PROVIDE A SELECTIVELY CHANGEABLE HEIGHT OF INDIVIDUAL SUPPORT ELEMENTS, CORRESPONDING MANUFACTURING METHOD AND CORRESPONDING USE**

(71) Applicant: ASML Netherlands B.V., 5500 AH Veldhoven (NL)
(72) Inventor: ENGELEN, Johannes, Bernardus, Charles, 5500 AH Veldhoven (NL)
(74) Representative: ASML Netherlands B.V.

(57) **Abstract**

There is provided an object holder configured to support an object, the object holder comprising a support surface having a plurality of support elements, wherein the plurality of support elements comprise a reversibly changeable crystalline/amorphous phase material configured to provide a selectively changeable height of individual support elements. Also provided is an object table comprising such an object holder, An apparatus for controlling the flatness of a surface comprising such an object holder, a lithographic apparatus or tool comprising such an object holder, a method of controlling the shape of a surface, a method of manufacturing an object holder, and the use of such apparatuses or method in a lithographic apparatus or process.

## Description

### FIELD

The present disclosure relates to an object holder, an object table, and a lithographic apparatus or tool comprising such an object holder or object table. The present disclosure also relates to a method of controlling the shape of a surface, and a method of manufacturing the object holder. Also described is the use of such an object holder, object table, lithographic apparatus or methods in a lithographic method or apparatus. The object holder may be part of an object table of a lithographic apparatus or lithographic tool. The present disclosure has particular, but not exclusive, application to EUV and DUV lithographic apparatuses and methods.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

The substrate to be exposed may be supported by a substrate holder (i.e. the object that directly supports a substrate), which in turn is supported by a substrate table. The substrate holder may have an array of projections or support elements, referred to as burls, projecting from at least one side. When the substrate rests on the top of the burls on the at least one side of the substrate holder, the substrate may be spaced apart from a main body of the substrate holder. This may aid in the prevention of a particle (i.e. a contaminating particle such as a dust particle), which may be present on the substrate holder, from distorting the substrate holder or substrate. The total surface area of the burls may only be a small fraction of the total area of the substrate or substrate holder. As such, it is more probable that any particle will lie between burls and its presence will have no effect. The tops of the burls define a plane on which objects lie when engaged therewith.

Due to the high accelerations that may be experienced by the substrate in use of a highthroughput lithographic apparatus, it may not be sufficient to allow the substrate simply to rest on the burls of the substrate holder. It is clamped in place. Two methods of clamping the substrate in place may be used - vacuum clamping and electrostatic clamping. In vacuum clamping, the space between the substrate holder and substrate and optionally between the substrate table and substrate holder are partially evacuated so that the substrate is held in place by the higher pressure of gas or liquid above it. Vacuum clamping, however, may not be used where the beam path and/or the environment near the substrate or substrate holder is kept at a low or very low pressure, e.g. for extreme ultraviolet (EUV) radiation lithography. In this case, it may not be possible to develop a sufficiently large pressure difference across the substrate (or substrate holder) to clamp it. Electrostatic clamping may, therefore, be used. In electrostatic clamping, a potential difference is established between the substrate and the substrate table and/or substrate holder. The potential difference may generate a clamping force.

It is important to control the flatness of the substrate, which may be, for example, a wafer. Whilst a substrate may have a flatness which in within specification when it is not in situ within a lithographic apparatus, the flatness may change when the substrate is held in position within a lithographic apparatus due to the forces acting upon it, such as those from electrostatic or vacuum clamping. In this way, the so-called functional flatness of the substrate, namely the flatness when in position for use, needs to be controlled as although the free substrate may be within specification, an in-situ substrate may not.

The present disclosure has been devised in an attempt to address at least some of the problems identified above.

### SUMMARY

According to a first aspect of the invention there is provided an object holder configured to support an object, the object holder comprising a support surface having a plurality of support elements, wherein the plurality of support elements comprise a reversibly changeable crystalline/amorphous phase material configured to provide a selectively changeable height of individual support elements

The flatness of object holders, such as wafer tables and wafer clamps, is adjusted by one of two methods. Firstly, ion-beam figuring (IBF) adjusts the flatness by etching the surface of the object holder by ion bombardment in an offline setup. By offline setup, it will be understood that this is outside of a lithographic apparatus used for imaging wafers. It is possible to correct the heights of individual burls, and the ability to do this is determined by the spot size of the ion beam. It is not possible to undertake IBF within a lithographic scanner as it requires an ion source and the removal of the material would cause contaminant materials to spread within the scanner and cause contamination issues. Another option for flatness correction is stoning, which is a mechanical polishing process in which it is not possible to control the height of individual burls. Mechanical polishing does not allow for correction of high-frequency differences in flatness, and also lacks spatial resolution since the polishing stones need to be larger than the support elements (burls) otherwise it could get stuck between burls. In addition, only the tallest burls are touched, so it is not possible to correct lower or shorter burls. Both of these existing methods are only able to reduce the height of the burls. Since different parts of the surface are subject to different rates of wear, to correct the flatness, it is necessary to lower all of the support elements to the height of the shortest support element. In addition, the burls may have a top layer coating which is necessary for optimal performance, but which would be made thinner or have desirable features diminished or removed, upon figuring by IBF or mechanical polishing. The present disclosure addresses the shortcomings of existing techniques, by providing a material which can be reversibly changed between crystalline and amorphous phases. Although it will be appreciated that materials contract and expand upon temperature change, this does not allow for the stable change in height of support elements, such as burls, whereas the use of materials which undergo a phase transition allows such changes in height to be stable. By stable it is understood that the phases does not change at the operating temperatures experienced in nominal use and over the timescale over which the object holder is in nominal use. In this way, the present disclosure allows for individual support elements, such a burls, to be adjusted. Since the height of the burls are adjusted without the removal of material, the adjustment may be effected within a scanner. This is further advantageous since the functional flatness of a substrate can differ between scanners, and it is not possible to correct for this external to the scanner. The present disclosure allows for the support surface to be made flat or unflat in order to correct for differences between individual scanners and ultimately provide a functional flatness that corrects for overlay and/or focus errors of other parts of the system, for example to correct for non-ideal focus plane and bring a specific wafer into focus. It will be appreciated that not all of the support elements need to comprise a phase change material.

The plurality of support elements may be burls.

The object holder may be a substrate holder. The object holder may be a wafer holder, such as a wafer table or wafer clamp. The object holder may be a reticle holder, such as a reticle clamp. Indeed the substrate holder may be any holder which requires micrometer or nanometer accuracy in flatness.

The plurality of support elements may comprise a top coating layer or material. It will be appreciated that the material comprising the top coating layer is different to the reversibly changeable crystalline/amorphous phase material. The top coating layer material may be any known top layer material and the present disclosure is not particularly limited by any top layer material.

The reversibly changeable crystalline/amorphous phase change material may be configured to change in height by up to and including around 10%. The tunable burl height is preferably in the range of ± 10 nm. The difference in volume of an amorphous and a crystalline phase of a material is up to around 10%, and so a 200 nm thick layer of such a material would be able to be tuned in height by around 20 nm. It will be appreciated that thinner or thicker layers may be used, with associated ranges for tunable height.

The reversibly changeable crystalline/amorphous phase material may comprise at least one chalcogenide glass having stable reversibly changeable crystalline/amorphous phases. Chalcogenide glasses have amorphous and crystalline states that can be controlled through heating and annealing. As such, it has been realised that by providing such materials within support elements, such as burls, it is possible to control the height of the burls by selective heating and annealing. These phase changes are reversible and are also stable. It will be appreciated that the phase change needs to be stable at the operating temperature of the object holder. The phase change occurs at around 600°C, which is much higher than the less than 100°C operating temperature of a wafer table of a lithographic apparatus.

The plurality of support elements may comprise one of or a combination of any of: a ternary compound of germanium, antimony, and tellurium (GST); germanium telluride; tin telluride; indium selenide; antimony selenide; antimony telluride; indium antimony selenide; indium antimony telluride; germanium antimony selenide; germanium antimony tellurium selenide; antimony;, and silver indium antimony telluride.

Taking GST as an example, at temperatures over around 600°C, the material becomes amorphous and can be cooled to an amorphous state. If the material is heated to above its crystallisation temperature, but below its melting point, it will form a crystalline phase. It is therefore possible to control the phase configuration, namely the ratio of phases in a material, to thereby control the height of the support element since the different phases have different densities.

The plurality of support elements may comprise from around 50 nm to around 300 nm of the reversibly changeable crystalline/amorphous phase material, from around 75 nm to around 250 nm of the reversibly changeable crystalline/amorphous phase material, or from around 100 nm to around 200 nm of the reversibly changeable crystalline/amorphous phase material.

Since the phase change material is able to expand by up to around 10%, the thickness of the phase change material layer can be selected to provide the desired range of height adjustment required for a given application.

It will be appreciated that not all of the support elements or burls necessarily comprise phase change material, although in some embodiments this is the case. In embodiments, support elements or burls which are subject to the greatest amount of wear in use are selected to comprise phase change material since such support elements or burls are most likely to require height adjustment.

The phase change material may be provided with a protective layer. The protective layer may cover the whole of the burls or just a portion. The protective layer may cover the sides of the support elements or burls and not the tip. Preferably, the protective layer covers all of the phase change material. The protective layer may preferably protect the phase change material from oxidation. Oxidation can lead to unwanted dimensional changes in the phase change material, so the provision of a protective layer reduces or prevents this. The protective layer may be provided on some or all of the burls.

According to a second aspect of the present disclosure, there is provided an object table comprising an object holder according to the first aspect.

According to a third aspect of the present disclosure, there is provided an apparatus for controlling the flatness of a surface comprising the object holder or object table according to the first or second aspect of the present disclosure and a means for changing a phase configuration of the reversibly changeable crystalline/amorphous phase material.

It will be appreciated that controlling the flatness does not necessarily mean making the surface as flat as possible, since it may be necessary to correct for errors in other parts of a system to which the apparatus is applied by providing an un-flat surface such that when a substrate is engaged with the surface, the substrate is deformed into a desired shape.

The means for changing the phase configuration may be any kind of heater, such as an electric heater or a laser. A laser may be preferred due to its high accuracy.

According to a fourth aspect of the present disclosure, there is provided a lithographic apparatus or tool comprising an object holder according to the first aspect, an object table according to the second aspect, or an apparatus according to the third aspect of the present disclosure.

According to a fifth aspect of the present disclosure, there is provided a method of controlling the shape of a surface, the method comprising: providing a surface comprising a plurality of support elements comprising a reversibly changeable crystalline/amorphous phase material, and controlling the phase configuration of the reversibly changeable crystalline/amorphous phase material to adjust the height of the support elements.

As described above, it is possible to control the shape of a surface by providing support elements with a phase change material that allows for the control of the height of such support elements. Previously, this was not possible to do in situ or reversibly.

Controlling the phase configuration of the reversibly changeable crystalline/amorphous phase material to adjust the height of the support elements may be achieved by selectively heating the material to a predetermined temperature and annealing, optionally by laser heating.

The method may further comprise measuring the shape of the surface, calculating a correction map required to adjust the surface to a desired shape, and applying the correction map to the surface by selectively applying heat to adjust the phase configuration of the of the reversibly changeable crystalline/amorphous phase material to adjust the height of the support elements.

The correction map determines how much the height of each support element needs to be altered such that when a substrate is engaged therewith, the substrate has the desired flatness. The correction map may be calculated including information such as, but not limited to, compressibility measurements of the surface, the source of unflatness, such as burl top contamination or projection optics focus correction.

Controlling the shape of the surface preferably takes place within a lithographic apparatus.

It was previously not possible to adjust the shape of a surface within a lithographic apparatus due to the risk of particle contamination. The present disclosure overcomes this shortcoming by allowing for *in situ* adjustment of the shape of a surface by way of changing the phase configuration of a phase change material.

According to a sixth aspect of the present disclosure, there is provide a method of manufacturing an object holder, the method comprising providing a reversibly changeable crystalline/amorphous phase material layer as an intermediate layer between a base layer and a top layer, and removing material from at least the top layer and the intermediate layer to provide a plurality of support elements.

The material may be removed by etching, such as, for example, by ion-beam etching or wet etching.

According to a seventh aspect of the present disclosure, there is provided the use of an object holder according to the first aspect, an object table according to the second aspect, an apparatus according to the third aspect, a lithographic apparatus according to the fourth aspect, or a method according to the fifth or sixth aspects of the present disclosure in a lithographic method or apparatus.

As described herein, the surface may be a plane extending perpendicular and over the top of the support elements, i.e. the plane defined by the tops of the support elements.

Various aspects and features of the invention set out above or below may be combined with various other aspects and features of the invention as will be readily apparent to the skilled person. All such combinations are explicitly considered and disclosed herein.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figures 2A to 2C schematically depict the adjustment of the height of a burl by heating: and
- Figures 3A to 3C schematically depict the adjustment of the height of a burl by heating.

### DETAILED DESCRIPTION

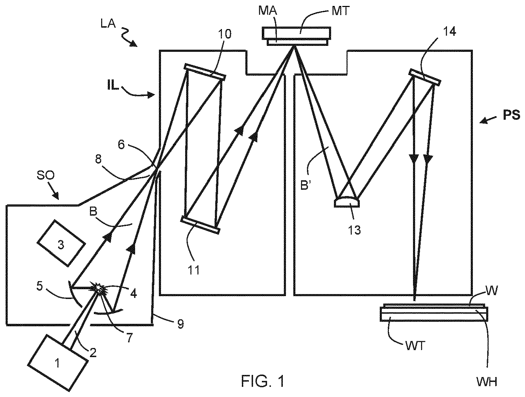

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and an object table WT. The object table WT may comprise an object holder WH configured to support an object W. The object W may be provided in the form of a substrate. The object table WT may be provided in the form of a substrate table. The object holder WH may be provided in the form of a substrate clamp. The substrate may be a wafer.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a COz laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during deexcitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure, which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

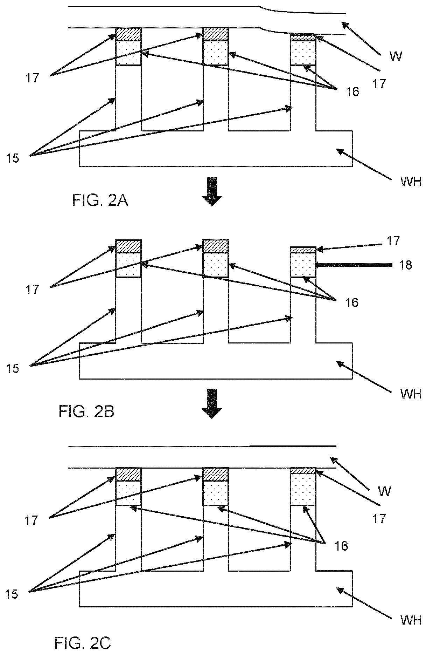

Figure 2A schematically depicts a portion of an object holder WH comprising a plurality of burls 15 supporting a substrate W. The burls 15 comprise a phase change material 16 and a capping material 17. Whilst it is preferable to include the phase change material 16 close to the top of the burls 15, the phase change material may be provide anywhere along the length of the burl beneath the capping material 17. For example, the phase change material may be located at a base of the burls 15 below a bulk of non-phase change material capped by a capping material 17. In embodiments of the present disclosure, the phase change material 16 is provided with a protective layer (not shown). The protective layer may cover the whole of the burls or just a portion. Preferably, the protective layer covers all of the phase change material. The protective layer may preferably protect the phase change material from oxidation. As shown in Figure 2A, the capping material 17 on one of the burls 15 is worn and so the height of the burl 15 is lower than the adjacent burls 15. The substrate W which is engaged with the object holder WH is therefore deformed and not flat. In order to remedy this, a laser beam 18 may be shone on the phase change material 16 in order to change the phase configuration of the phase change material 16. As shown in Figure 2C, due to the presence of the phase change material 16, the height of the burls 15 has been modified such that when a substrate W is engaged with the burls 15, the substrate W is flat.

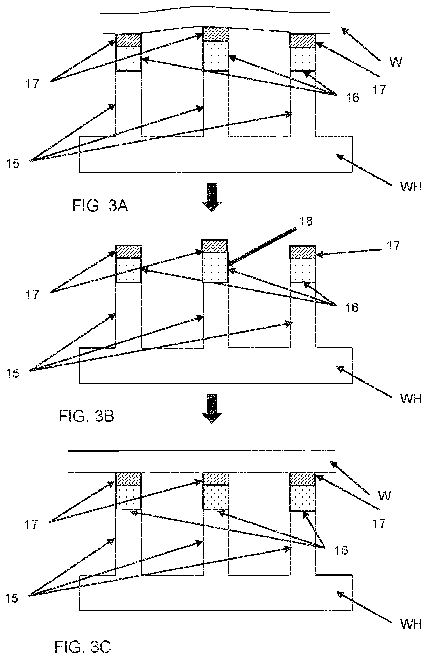

Figures 3A to 3C are similar to Figures 2A to 2C, albeit Figures 3A to 3C depict the case where the change in the phase configuration of the phase change material 16 is used to reduce the height of one of the burls 15 to provide a flat substrate W. It will be appreciated that in certain cases, it may be desirable to have the burls 15 of different heights to provide functional flatness to the substrate W. It will also be appreciated that the angle of the laser beam 18 is arbitrarily depicted.

In use, the individual burls 15 are controlled in height by the selective heating and annealing of the phase change material 16 forming at least part of the burls 15. Any suitable heating method may be used, but lasers are preferred due to their accuracy and precision. The heat source may be focused on a single burl or a group of burls. The degree of heating and rate of cooling can be controlled by adjusting the intensity and duration of laser pulses. By adjusting the intensity and duration of laser pulses, it is possible to provide the desired surface shape by adjusting the heights of the burls 15. The change in height of the burls is stable in the normal operating temperature range of the substrate holder WH, which may be from 0°C to 100°C such that a change of phase and physical properties is only enacted by the intended heat source.

**Table 1 below compares the properties of crystalline and amorphous phases of GST material.**

| | GST Crystalline Phase | GST Amorphous Phase |
|---|---|---|
| Biaxial Modulus (GPa) | 37 | 30 |
| CTE (ppm/K) | 17 | 13 |
| Volume relative to crystalline GST phase | 100% | 110% |

As can be seen, amorphous GST material has a volume around 10% greater than the crystalline phase. As such, by controlling the ratio of crystalline phase to amorphous phase (the phase configuration), it is possible to adjust the volume of the material. Since the burls have a high aspect ratio in that they are taller than they are wider, the expansion is primarily observed as an increase in height.

It will be understood that references to a plurality of features may be interchangeably used with references to singular forms of those features, such as for example "at least one" and/or "each". Singular forms of a feature, such as for example "at least one" or "each," may be used interchangeably.

Although embodiments of the invention have been described in connection with a substrate, a substrate holder and a substrate table, in other embodiments the invention may be used to clamp a mask MA (or other patterning device) to a support structure MT of a lithographic apparatus (see Figure 1), or to clamp some other object.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions. An object holder according to an embodiment of the invention may form part of a lithographic tool.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Aspects of the present disclosure are described in the following numbered clauses:
1. An object holder configured to support an object, the object holder comprising a support surface having a plurality of support elements, wherein the plurality of support elements comprise a reversibly changeable crystalline/amorphous phase material configured to provide a selectively changeable height of individual support elements.
2. The object holder according to clause 1, wherein the plurality of support elements are burls.
3. The object holder according to clause 1 or clause 2, wherein the object holder is a substrate holder.
4. The object holder of any preceding clause, wherein the object holder is a wafer holder, preferably a wafer table or wafer clamp, or a reticle holder, such as a reticle clamp.
5. The object holder of any preceding clause, wherein the plurality of support elements comprise a top coating material.
6. The object holder of any preceding clause, wherein the phase change material is configured to change in height by up to and including around 10%.
7. The object holder of any preceding clause, wherein the reversibly changeable crystalline/amorphous phase material comprises at least one chalcogenide glass having stable reversibly changeable crystalline/amorphous phases.
8. The object holder of any preceding clause, wherein the plurality of support elements comprises one of or a combination of any of: a ternary compound of germanium, antimony, and tellurium (GST); germanium telluride; tin telluride; indium selenide; antimony selenide; antimony telluride; indium antimony selenide; indium antimony telluride; germanium antimony selenide; germanium antimony tellurium selenide; antimony;, and silver indium antimony telluride.
9. The object holder of any preceding clause, wherein a plurality of the support elements comprise from around 50 nm to around 300 nm of the reversibly changeable crystalline/amorphous phase material, from around 75 nm to around 250 nm of the reversibly changeable crystalline/amorphous phase material, or from around 100 nm to around 200 nm of the reversibly changeable crystalline/amorphous phase material.
10. The object holder of any preceding clause, wherein a protective layer is provided on at least some of the support elements.
11. An object table comprising an object holder according to any preceding clause.
12. An apparatus for controlling the flatness of a surface comprising the object holder according to any preceding clause 1-10 or an object table according to clause 11, and comprising a means for changing a phase configuration of the reversibly changeable crystalline/amorphous phase material.
13. The apparatus according to clause 12, wherein the means comprises a laser and/or an electrical heater.
14. A lithographic apparatus or tool comprising the object holder of any of clauses 1 to 10, an object table according to clause 11, or apparatus according to clauses 12 or 13.
15. A method of controlling the shape of a surface, the method comprising: providing a surface comprising a plurality of support elements comprising a reversibly changeable crystalline/amorphous phase material, and controlling the phase configuration of the reversibly changeable crystalline/amorphous phase material to adjust the height of the support elements.
16. The method according to clause 15, wherein controlling the phase configuration of the reversibly changeable crystalline/amorphous phase material to adjust the height of the support elements is achieved by selectively heating the material to a predetermined temperature and annealing, optionally by laser heating.
17. The method according to clause 15 or 16, the method further comprising measuring the shape of the surface, calculating a correction map required to adjust the surface to a desired shape, and applying the correction map to the surface by selectively applying heat to adjust the phase configuration of the of the reversibly changeable crystalline/amorphous phase material to adjust the height of the support elements.
18. The method according to any of clauses 16 to 17, wherein controlling the shape of the surface takes place within a lithographic apparatus.
19. A method of manufacturing an object holder, the method comprising providing a reversibly changeable crystalline/amorphous phase material layer as an intermediate layer between a base layer and a top layer, and removing material from at least the top layer and the intermediate layer to provide a plurality of support elements.
20. The method of clause 19, wherein the material is removed by etching, optionally ion-beam etching or wet etching.
21. The use of an object holder according to any of clause 1 to 10, an object table according to clause 11, an apparatus according to clauses 12 or 13, a lithographic apparatus according to clause 14, or a method according to any of clauses 15 to 20 in a lithographic method or apparatus.

## Claims

1. An object holder configured to support an object, the object holder comprising a support surface having a plurality of support elements, wherein the plurality of support elements comprise a reversibly changeable crystalline/amorphous phase material configured to provide a selectively changeable height of individual support elements.

2. The object holder according to claim 1, wherein the plurality of support elements are burls, and/or wherein the plurality of support elements comprise a top coating material.

3. The object holder according to claim 1 or claim 2, wherein the object holder is a substrate holder, optionally wherein the object holder is a wafer holder, preferably a wafer table or wafer clamp, or a reticle holder, such as a reticle clamp.

4. The object holder of any preceding claim, wherein the reversibly changeable crystalline/amorphous phase change material is configured to change in height by up to and including around 10%.

5. The object holder of any preceding claim, wherein the reversibly changeable crystalline/amorphous phase material comprises at least one chalcogenide glass having stable reversibly changeable crystalline/amorphous phases.

6. The object holder of any preceding claim, wherein the plurality of support elements comprises one of or a combination of any of: a ternary compound of germanium, antimony, and tellurium (GST); germanium telluride; tin telluride; indium selenide; antimony selenide; antimony telluride; indium antimony selenide; indium antimony telluride; germanium antimony selenide; germanium antimony tellurium selenide; antimony;, and silver indium antimony telluride.

7. The object holder of any preceding claim, wherein a plurality of the support elements comprise from around 50 nm to around 300 nm of the reversibly changeable crystalline/amorphous phase material, from around 75 nm to around 250 nm of the reversibly changeable crystalline/amorphous phase material, or from around 100 nm to around 200 nm of the reversibly changeable crystalline/amorphous phase material.

8. The object holder of any preceding claim, wherein a protective layer is provided on at least some of the support elements.

9. An object table comprising an object holder according to any preceding claim.

10. An apparatus for controlling the flatness of a surface comprising the object holder according to any preceding claim and a means for changing a phase configuration of the reversibly changeable crystalline/amorphous phase material, optionally wherein the means comprises a laser and/or an electrical heater.

11. A lithographic apparatus or tool comprising the object holder of any of claims 1 to 8, object table of claim 9, or apparatus according to claim 10.

12. A method of controlling the shape of a surface, the method comprising: providing a surface comprising a plurality of support elements comprising a reversibly changeable crystalline/amorphous phase material, and controlling the phase configuration of the reversibly changeable crystalline/amorphous phase material to adjust the height of the support elements.

13. The method according to claim 12, wherein controlling the phase configuration of the reversibly changeable crystalline/amorphous phase material to adjust the height of the support elements is achieved by selectively heating the material to a predetermined temperature and annealing, optionally by laser heating,
and/or the method further comprising measuring the shape of the surface, calculating a correction map required to adjust the surface to a desired shape, and applying the correction map to the surface by selectively applying heat to adjust the phase configuration of the of the reversibly changeable crystalline/amorphous phase material to adjust the height of the support elements,
and/or wherein controlling the shape of the surface takes place within a lithographic apparatus.

14. A method of manufacturing an object holder, the method comprising providing a reversibly changeable crystalline/amorphous phase material layer as an intermediate layer between a base layer and a top layer, and removing material from at least the top layer and the intermediate layer to provide a plurality of support elements, optionally, wherein the material is removed by etching, optionally ion-beam etching or wet etching.

15. The use of an object holder according to any of claim 1 to 8, an object table according to claim 9, an apparatus according to claim 10, a lithographic apparatus according to claim 11, or a method according to any of claims 12 to 14 in a lithographic method or apparatus.
